# EUROPEAN PATENT APPLICATION

(11) **EP 4 661 065 A1**
(43) Date of publication of application: **10.12.2025**
(21) Application number: 24749642.5
(22) Date of filing: 29.01.2024
(51) Int. Cl.: H01L 21/683, H01L 21/67

(54) **TRANSFER APPARATUS, SEMICONDUCTOR PROCESS DEVICE AND WAFER TRANSFER METHOD**

(30) Priority: 31.01.2023 CN 202310049116
(71) Applicant: Beijing NAURA Microelectronics Equipment Co., Ltd., Beijing 100176 (CN)
(72) Inventor: LV, Chao, Beijing 100176 (CN); LI, Xue, Beijing 100176 (CN)
(74) Representative: Cohausz & Florack
(86) International application number: PCT/CN2024/074379
(87) International publication number: WO 2024/160162

(57) **Abstract**

The present disclosure discloses a transfer device, semiconductor process equipment, and a wafer transfer method, and involves the semiconductor field. A transfer device includes an adsorption finger, a heating element, a first temperature measurement element, a second temperature measurement element, and a control element. The adsorption finger includes an adsorption member configured to adsorb the wafer. The heating element and the first temperature measurement element are arranged at the adsorption member. The second temperature measurement element is arranged at the adsorption finger and spaced apart from the adsorption member. The control element is electrically connected to the heating element, the first temperature measurement element, and the second temperature measurement element. The control element is configured to, when a temperature measured by the second temperature measurement element is higher than a temperature measured by the first temperature measurement element, and according to a difference between the temperature measured by the second temperature measurement element and the temperature measured by the first temperature measurement element, control the heating element to heat the adsorption member to cause the temperature difference to be within the preset temperature difference range. The present disclosure can solve the issue of warping of the wafer due to the large temperature difference between the adsorption plate of the manipulator and the wafer.

## Description

### TECHNICAL FIELD

The present disclosure generally relates to the semiconductor technology field and, more particularly, to a transfer device, semiconductor processing equipment, and a wafer transfer method.

### BACKGROUND

In a front-end transfer module of equipment, the main transfer member for a wafer is a manipulator, whose primary task is to accurately transfer the wafer to a process module. A common wafer fetch method for the manipulator includes an adsorption type, a mechanical clamping, and a friction type. An appropriate fetch method is selected based on factors such as the size and material of a transferred item, a transfer environment (vacuum or atmospheric), and transfer efficiency.

A semiconductor wafer material mostly includes silicon and related compounds of silicon. To protect the wafer surface from scratches or damage, and to improve transfer efficiency in an atmospheric transmission environment, the adsorption fetch method is often employed, and an adsorption-type manipulator is selected.

However, in some cases, when the wafer is in a high-temperature state, after a suction plate of the manipulator contacts the wafer, the temperature distribution of the wafer is not uniform when the temperature difference between the manipulator and the wafer is large. Then, a portion of the wafer warps, which significantly impacts product quality.

### SUMMARY

The purpose of embodiments of the present disclosure is to provide a transfer device, semiconductor process equipment, and a wafer transfer method, which solves the issue of warping of the wafer due to a large temperature difference between the adsorption plate of the manipulator and the wafer.

To solve the above technical problem, the present disclosure is implemented as follows.

Embodiments of the present disclosure provide a transfer device configured to adsorb and transfer a wafer and including an adsorption finger, a heating element, a first temperature measurement element, a second temperature measurement element, and a control element.

The adsorption finger includes an adsorption member configured to adsorb the wafer. The heating element and the first temperature measurement element are arranged at the adsorption member. The second temperature measurement element is arranged at the adsorption finger and spaced apart from the adsorption member, and the second temperature measurement element is configured to measure temperature above or below the adsorption finger.

The control element is electrically connected to the heating element, the first temperature measurement element, and the second temperature measurement element. The control element is configured to, when a temperature measured by the second temperature measurement element is higher than a temperature measured by the first temperature measurement element, and a difference between the temperature measured by the second temperature measurement element and the temperature measured by the first temperature measurement element is greater than a preset temperature difference, control the heating element to heat the adsorption member to cause the difference to be smaller than or equal to the preset temperature difference.

Embodiments of the present disclosure further provide semiconductor process equipment, including the above transfer device.

Embodiments of the present disclosure further provide a wafer transfer method, applied to the above transfer device, and including:
controlling the adsorption member of the adsorption finger to be below or above the wafer;
measuring a temperature of the adsorption member by the first temperature measurement element, and measuring a temperature of the wafer by the second temperature measurement element;
when the temperature measured by the second temperature measurement element is higher than the temperature measured by the first temperature measurement element, and the difference between the temperature measured by the second temperature measurement element and the temperature measured by the first temperature measurement element is greater than a preset temperature difference, controlling the heating element to heat the adsorption member to cause the difference to be less than or equal to the preset temperature difference; and
controlling the adsorption member to adsorb the wafer, and controlling the adsorption finger to move to transfer the wafer.

In embodiments of the present disclosure, the first temperature measurement can be configured to measure the temperature of the adsorption member. The second temperature measurement can be configured to measure the temperature of the wafer. The first temperature measurement element and the second temperature measurement element can send the temperature information measured by the first temperature measurement element and the second temperature measurement element to the control element. After the control element analyzes and compares the temperature information, the control element can control the heating element to perform work accordingly to cause the temperature difference between the adsorption member and the wafer to be smaller than or equal to the preset temperature difference. In some embodiments, the control element can be configured to control the heating element to heat the adsorption member to cause the difference to be smaller than or equal to the preset temperature difference when the temperature measured by the second temperature measurement element is higher than the temperature measured by the first temperature measurement element, and the difference between the temperature measured by the second temperature measurement element and the temperature measured by the first temperature measurement element is greater than the preset temperature difference. Then, the warping of the wafer 400 due to the uneven temperatures at different positions of the wafer caused by the temperature difference between the wafer 400 and the adsorption member can be alleviated. Therefore, in embodiments of the present disclosure, the temperature uniformity of the wafer can be improved by reducing the temperature difference between the adsorption member and the wafer to ensure the wafer quality.

### BRIEF DESCRIPTION OF THE DRAWINGS

FIG. 1 is a first schematic diagram of a transfer device and a wafer according to an embodiment of the present disclosure.
FIG. 2 is a second schematic diagram of a transfer device and a wafer according to an embodiment of the present disclosure.
FIG. 3 is a schematic structural diagram of an absorb finger according to an embodiment of the present disclosure.
FIG. 4 is a first local schematic diagram of a protrusion structure according to an embodiment of the present disclosure.
FIG. 5 is a second local schematic diagram of a protrusion structure according to an embodiment of the present disclosure.
FIG. 6 is a local schematic diagram showing a wafer in contact with a protrusion structure according to an embodiment of the present disclosure, wherein a) a negative pressure air hole is arranged around a finger member, and b) a center hole member and an annular groove member are provided.
FIG. 7 is a schematic comparison curve of absorption effects in a manner with a negative pressure air hole arranged around a finger member and in a manner with a center hole member and an annular groove member according to an embodiment of the present disclosure.
FIG. 8 is a schematic comparison curve of absorption effects in a manner with a negative pressure air hole arranged around a finger member before and after a temperature rise according to an embodiment of the present disclosure, wherein a) a pre-temperature rise state, and b) a post-temperature rise state.
FIG. 9 is a schematic comparison curve of absorption effects in a manner with a negative pressure air hole arranged around a finger member and in a manner with a center hole member and an annular groove member before and after a temperature rise according to an embodiment of the present disclosure, wherein a) the manner with the negative pressure air hole arranged around the finger member, and b) the manner with the center hole member and the annular groove member.
FIG. 10 is a schematic diagram of a temperature control circuit of an absorption finger according to an embodiment of the present disclosure.
FIG. 11 is a schematic diagram showing a temperature control principle according to an embodiment of the present disclosure.
FIG. 12 is a schematic flowchart of a temperature control according to an embodiment of the present disclosure.
FIG. 13 is a schematic structural diagram of a transfer device, a mounting base, and a mechanical arm according to an embodiment of the present disclosure.
FIG. 14 is a schematic transfer flowchart of a wafer transfer method according to an embodiment of the present disclosure.
FIG. 15 is a schematic diagram showing an absorption finger being in a low position during a wafer transfer process according to an embodiment of the present disclosure.
FIG. 16 is a schematic diagram showing an absorption finger lifting a wafer during a wafer transfer process according to an embodiment of the present disclosure.
FIG. 17 is a schematic diagram showing an absorption finger absorbing a wafer during a wafer transfer process according to an embodiment of the present disclosure.

### Reference numerals:

| | | | | | |
|---|---|---|---|---|---|
| 100 | Transfer device | 110 | Absorption finger | 111 | Protrusion structure |
| 112 | Absorption hole | 1121 | Center hole member | 1122 | Annular groove member |
| 113 | Notch | 115 | Air channel | 120 | Heating element |
| 130 | First temperature measurment element | 140 | Second temperature measurement element | | |
| 150 | Control element | | | | |
| 200 | Mounting base | | | | |
| 300 | Mechanical arm | | | | |
| 400 | Wafer | 410 | Warping member | | |

### DETAILED DESCRIPTION OF THE EMBODIMENTS

The technical solutions of embodiments of the present disclosure are described in detail in connection with the accompanying drawings of embodiments of the present disclosure. Obviously, the embodiments described are only some embodiments of the present disclosure, not all embodiments. Based on embodiments of the present disclosure, all other embodiments obtained by those of ordinary skill in the art without creative efforts fall within the scope of the present disclosure.

The terms "first" and "second" in the specification and claims of the present disclosure are used to distinguish similar objects and are not intended to describe a specific order or sequence. It should be understood that the data used in this way may be interchanged under appropriate circumstances, so that embodiments of the present disclosure can be implemented in orders other than those illustrated or described herein. The objects distinguished by "first" and "second" are generally of the same type, and the number of objects is not limited. For example, a first object may be one or more. In addition, "and/or" in the specification and claims indicates at least one of the connected objects, and the character "/" generally indicates that the associated objects are in an "or" relationship.

Embodiments of the present disclosure are described in detail with reference to the accompanying drawings and specific embodiments and application scenarios.

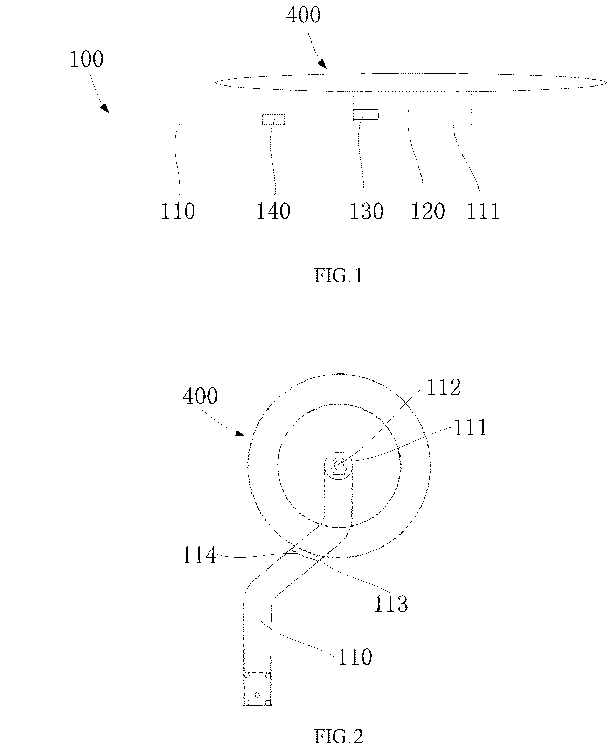

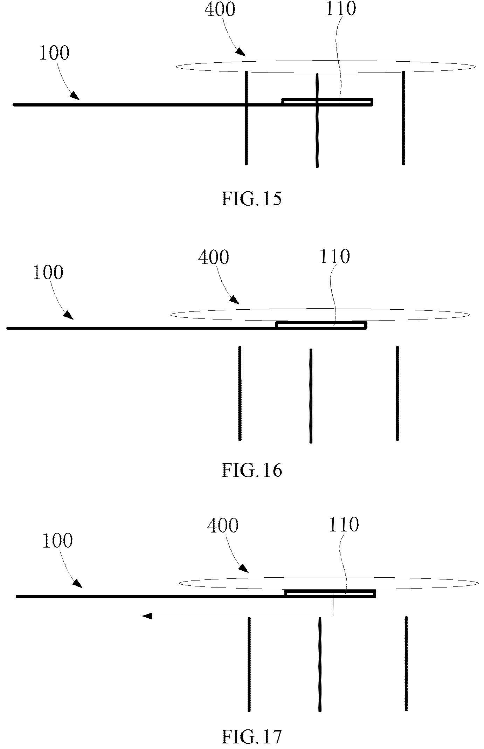

As shown in FIGs. 1 to 17, embodiments of the present disclosure provide a transfer device 100 configured to absorb and transfer a wafer 400. Thus, the wafer 400 does not move arbitrarily during the transfer process.

In embodiments of the present disclosure, the transfer device 100 includes an adsorption finger 110, a heating element 120, a first temperature measurement element 130, a second temperature measurement element 140, and a control element 150. The adsorption finger 110 can include an adsorption member configured to adsorb the wafer 400. The adsorption member contacts the surface of the wafer 400 and ensures that the wafer 400 and the adsorption member are closely attached under an adsorption force to adsorb the wafer 400 and prevent the wafer 400 from moving arbitrarily.

For example, the wafer 400 can be located on the upper surface of the adsorption member. In this case, the adsorption member can adsorb and support the wafer 400. Thus, under the combined action of support and adsorption, the wafer 400 can be adhered firmly to the adsorption member to prevent the wafer 400 from detaching from or moving relative to the adsorption member to affect normal transfer of the wafer 400 or reduce the positional accuracy of the wafer 400. Additionally, the adsorption finger 110 can be an I-shaped ceramic finger, or other types, which are not limited here.

To determine the temperature of the adsorption member, the first temperature measurement element 130 can be arranged at the adsorption member in embodiments of the present disclosure. Then, the first temperature measurement element 130 can be configured to detect the temperature of the adsorption member in real time to lay the foundation for subsequent temperature adjustment of the adsorption member.

Considering that the wafer 400 is carried and transferred by the adsorption member of the adsorption finger 110, to measure the temperature of the wafer 400, in some embodiments, the second temperature measurement element 140 can be arranged at the adsorption finger 110 and spaced apart from the adsorption member. The second temperature measurement element 140 can be configured to measure the temperature above or below the adsorption finger 110. For example, when the wafer 400 is adsorbed on the adsorption member, a portion of the wafer 400 can be located above or below the second temperature measurement element 140, and the second temperature measurement element 140 can face the surface of the wafer 400. Then, the second temperature measurement element 140 can be configured to measure the temperature of the wafer 400 adsorbed by the adsorption member to lay the foundation for subsequent temperature adjustment of the adsorption member. When no wafer 400 is on the adsorption member, the temperature measured by the second temperature measurement element 140 can be the ambient temperature above or below the adsorption finger 110. It is easy to understand that the surface of the adsorption finger 110 carrying the wafer 400 can face upward or downward, and the temperature measurement direction of the second temperature measurement element 140 can always be consistent with the orientation of the surface of the adsorption finger 110 carrying the wafer 400. The following description takes the surface of the adsorption finger 110 carrying the wafer 400 facing upward as an example.

Further, the control element 150 can be electrically connected to the first temperature measurement element 130 and the second temperature measurement element 140 to allow the first temperature measurement element 130 and the second temperature measurement element 140 to transmit the detected temperature information to the control element 150. The control element 150 can be configured to compare, analyze, and process the temperature information to determine the temperature of the adsorption member and the temperature of the wafer 400.

For example, the control element 150 can adopt a combination of control elements, such as a temperature controller and a solid-state relay, to form a control circuit. The temperature controller and the solid-state relay can be arranged inside the adsorption finger 110 or the mechanical arm 300. Thus, the wafer transfer of the transfer device may not be affected.

Considering that when the temperature of the wafer 400 is too high or too low, a large temperature difference between the wafer 400 and the adsorption member can result. In this case, when the wafer 400 contacts the adsorption member, the wafer 400 and the adsorption member can have heat exchange to allow the local temperature to change where the wafer 400 contacts the adsorption member. Thus, a large difference can exist between the portion of the wafer 400 contacting the adsorption member and the portion of the wafer 400 not contacting the adsorption member. According to the principle of thermal expansion and contraction, when the temperature is uneven, different deformations can happen at different parts of the wafer 400 to eventually cause the wafer 400 to have an obvious warping deformation to affect the quality of the wafer 400.

To alleviate the warping issue of wafer 400, in embodiments of the present disclosure, when the wafer 400 is in a high-temperature state, the heating element 120 can be arranged on the adsorption member. When the temperature of the heating element 120 rises, the temperature of the adsorption member can rise. Then, the difference between the temperature of the adsorption member and the temperature of the wafer 400 can be reduced after the temperature of the heating element 120 rises, which is beneficial to reduce the warping degree of the wafer 400. On the contrary, during the heating process, if the temperature of the wafer 400 is lower than the temperature of the adsorption member, the heating element 120 can stop working to cause the temperature of the adsorption member to decrease. Then, the heat transferred to the adsorption member can be reduced by turning off the heating element 120. Thus, the difference between the temperature of the adsorption member and the temperature of the wafer 400 can be reduced, which is also beneficial to reduce the warping degree of the wafer 400. In addition, the heating element 120 can also be electrically connected to the control element 150 to allow the heating element 120 to operate under the control of the control element 150.

In embodiments of the present disclosure, when the temperature measured by the second temperature sensor 140 is higher than the temperature measured by the first temperature sensor 130, and the difference of the temperatures is greater than a preset temperature difference, the control element 150 can control the heating element 120 to heat the adsorption member to allow the difference between the temperature measured by the second temperature sensor 140 and the temperature measured by the first temperature sensor 130 to be smaller than or equal to the preset temperature difference. For example, the preset temperature difference can be, e.g., 0.5 °C. Of course, the preset temperature difference can be other temperature values, which are not limited here.

In embodiments of the present disclosure, the first temperature sensor 130 can be configured to measure the temperature of the adsorption member, and the second temperature sensor 140 can be configured to measure the temperature of the wafer 400. The first temperature sensor 130 and the second temperature sensor 140 can transmit the measured temperature information to the control element 150. After the control element 150 analyzes and compares, the control element 150 can control the heating element 120 to perform the corresponding work. Thus, the difference between the temperature of the adsorption member and the temperature of the wafer 400 can be smaller than or equal to the preset temperature difference. Thus, the uneven temperature at different parts of the wafer 400 after the adsorption member contracts the wafer 400 due to the large temperature difference between the adsorption member and the wafer 400 to cause the warping issue of the wafer 400 can be alleviated. Therefore, in embodiments of the present disclosure, the temperature difference between the adsorption member and the wafer 400 can be reduced to ensure the uniformity of the temperature of the wafer 400 to improve the quality of the wafer 400.

In embodiments of the present disclosure, the control element 150 can be also configured to control the heating element 120 to heat the adsorption member when the temperature measured by the second temperature sensor 140 is smaller than or equal to the preset temperature to ensure the temperature measured by the first temperature measure element 130 to maintain within the preset temperature range. For example, the preset temperature can be 60 °C.), The preset temperature range can be around 60 °C, for example, 59.5 °C, 59.7 °C, 59.9 °C, 60.2 °C, and 60.5 °C). Of course, the preset temperature can be other temperature values, which are not limited here.

It needs to be noted that when no wafer 400 is adsorbed at the adsorption member, or the adsorbed wafer 400 has a room temperature, the temperature detected by the second temperature measurement element 140 can be the ambient temperature of the room, which is smaller than or equal to the preset temperature. Then, the control element 150 can be configured to control the heating element 120 to heat the adsorption member to cause the temperature of the adsorption member to be maintained in the preset temperature range. Thus, the adsorption member can be ensured to be in a constant temperature state, which is beneficial to preheat the adsorption member to improve the process efficiency. It needs to be noted that when the temperature of the adsorbed wafer 400 is room temperature (e.g., 25 °C), the temperature of the adsorption member can be maintained within the preset temperature range (e.g., 60 °C). Then, the difference between the temperature of the wafer 400 and the temperature of the adsorption member can exist. However, since the wafer 400 is in the low temperature state, the possibility of the temperature difference causing the warping of the wafer 400 is low.

It needs to be noted that when the adsorption member adsorbs the wafer 400, whether the temperature measured by the second temperature measurement element 140 is greater than the above preset temperature (e.g., 60 °C) can be determined first, if yes, whether the temperature measured by the second temperature measurement element 140 is greater than the temperature measured by the first temperature measurement element 130 can be determined. If yes, whether the difference of the temperature measured by the second temperature measurement element 140 and the temperature measured by the first temperature measurement element 130 is greater than the preset temperature difference can be determined. If yes, the control element 150 can control the heating element 120 to heat the adsorption member to cause the temperature of the adsorption member to rise until the above difference is smaller than or equal to the above preset temperature difference. It can be easy to understand that when the temperature measured by the second temperature measurement element 140 is greater than the temperature measured by the first temperature measurement element 130, the difference can be a positive number or zero. determined.

As shown in FIGs. 2 to 5, in some embodiments, the adsorption member includes a protrusion structure 111, and the protrusion structure 111 can be used as the adsorption member. The protrusion structure 111 is configured to carry and adsorb the wafer 400 to ensure the wafer 400 remains stable during the transfer. In addition, an adsorption hole 112 is formed on an end surface of the protrusion structure 111 in contact with the wafer 400. Air can be sucked out through the adsorption hole 112 to form a negative pressure area near the end surface of the protrusion structure 111 in contact with the wafer 400. Thus, when the wafer 400 is arranged on the end surface of the protrusion structure 111, the wafer 400 can be adsorbed. In some embodiments, the protrusion structure 111 can be arranged at an end of the adsorption finger 110. It can be noted that the end of the adsorption finger 110 provided with the protrusion structure 110 can normally be an end away from the mechanical arm 300.

To extract the air, the transfer device can further include an air channel 115 arranged at the adsorption finger 110 and communicating with the adsorption hole 112. In some embodiments, an end of the air channel 115 can communicate with the adsorption hole 112. The other end of the air channel 115 can be connected to an air extraction device (not shown in the figure). Thus, when the air extraction device operates, the air near the end of the protrusion structure 111 in contact with the wafer 400 can be continuously extracted by the air extraction device via the adsorption hole 112 and the air channel 115. Then, the negative pressure area can be formed near the end of the protrusion structure 111 to adsorb the wafer 400.

For example, along a protruding direction of the protrusion structure 111, the air channel 115 can be away from the surface of the protrusion structure 111 facing the wafer 400. With this arrangement, the air channel 115 can communicate with the end of the adsorption hole 112 away from the wafer 400. Additionally, the air channel 115 can extend from the end of the adsorption finger 110 near the mechanical arm 300 toward the end away from the mechanical arm 300, ultimately extending to the center of the adsorption hole 112. With this arrangement, the communication area between the air channel 115 and the adsorption hole 112 can be increased to improve the vacuum extraction effect of the adsorption hole 112.

Furthermore, the heating element 120 and the first temperature measurement element 130 can be arranged inside the protrusion structure 111. Then, the heating element 120 can directly heat the protrusion structure 111 to cause the temperature of the protrusion structure 111 to rise. Moreover, the first temperature measurement element 130 can directly measure the temperature of the protrusion structure 111 in real time to ensure the accuracy of temperature rise and temperature measurement for the protrusion structure 111. Meanwhile, the protrusion structure 111 can also provide protection for the heating element 120 and the first temperature measurement element 130 to prevent interference or damage from the external environment to the heating element 120 and the first temperature measurement element 130.

For example, the heating element 120 can be an electric heating coil, which is arranged in a surrounding manner inside the protrusion structure 111. With this arrangement, the heating area can be increased to a certain degree to improve the temperature rising speed of the protrusion structure 111 and the uniformity of the temperature rising of the protrusion structure 111. Of course, the heating element 120 can also be a heating plate, heating tube, or another structure, which is not limited. In some embodiments, the electric heating coil can be arranged around the adsorption hole 112 to heat the local area of the adsorption member near the adsorption hole 112 to ensure a minimal temperature difference between the adsorption member and the wafer 400 when the adsorption member is in contact with the wafer 400.

Additionally, the air channel 115 can communicate with the center hole member 1121 and the annular groove member 1122 to extract the air from the center hole member 1121 and the annular groove member 1122. Thus, a negative pressure area can be formed near each of the center hole member 1121 and the annular groove member 1122 to improve the adsorption effect for the wafer 400.

The first temperature measurement element 130 can be a thermocouple, temperature sensor, temperature transmitter, etc., as long as the first temperature measurement element 130 can accurately measure the temperature of the protrusion structure 111, whose type is not limited.

The second temperature measurement element 140 can be a non-contact temperature measurement device, as long as the second temperature measurement element 140 can accurately measure the temperature of the wafer 400, whose type is not limited. In some embodiments, an infrared temperature sensor can be configured to measure the temperature of the wafer 400 to ensure the accuracy of the temperature measurement.

It should be noted that the wafer 400 can realize a good adsorption effect on the wafer 400 when the wafer 400 is in close contact with the end surface of the protrusion structure 111. However, due to temperature difference along the radial direction of the wafer 400, the wafer 400 can have micro warping members 410 at different positions in the radial direction of the wafer 400. Then, when the area covered by the adsorption hole 112 is larger, the area needed to be closely attached to the wafer 400 can be larger, which increases the probability for the warping members 410 to overlap with the area covered by the adsorption hole 112. Thus, when the warping members 410 have some overlapping areas with the area covered by the adsorption hole 112, a wedge-shaped space can be formed between the surface of the wafer 400 and the end surface of the protrusion structure 111. With the wedge-shaped space, the external air can enter the adsorption hole 112. Thus, the adsorption effect on the wafer 400 may not be good. Therefore, the wafer 400 can be easily detached from or can move relative to the protrusion structure 111 to affect the normal transfer of the wafer 400.

Based on the above, the adsorption hole 112 can be arranged at a center area of the end surface of the protrusion structure 111 in contact with the wafer 400. With this arrangement, a negative pressure area formed at the end surface of the protrusion structure 111 can be closer to the center area of the wafer 400. For example, the size of the protrusion structure 111 is typically smaller than or equal to 42 mm, and a distance between the edge of the adsorption hole 112 and the edge of the protrusion structure 111 can be greater than or equal to 10 mm. Thus, the wedge-shaped space may not be formed after the warping members 410 of the wafer 400 contact the end surface of the protrusion structure 111 to improve the adsorption effect.

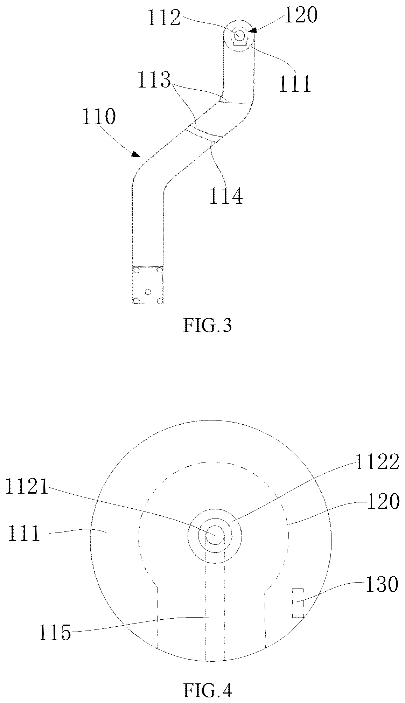

Further, as shown in FIGs. 4 to 6, the adsorption hole 112 includes a center hole member 1121 and an annular groove member 1122. The center hole member 1121 is located at the center of the end surface of the protrusion structure 111 in contact with the wafer 400. The annular groove member 1122 is arranged around the center hole member 1121. The air near the end surface of the protrusion structure 111 can be extracted via the center hole member 1121 and the annular groove member 1122 to cause the end surface of the protrusion structure 111 to form the negative pressure areas near the center hole member 1121 and the annular groove member 1122. When the wafer 400 is placed on the end surface of the protrusion structure 111, the wafer 400 can be adsorbed through the center hole member 1121 and the annular groove member 1122 to ensure that the wafer 400 does not detach from or move relative to the protrusion structure 111.

Compared to the method of forming negative pressure holes around the finger member of the adsorption finger 110, in embodiments of the present disclosure, the center hole member 1121 and annular groove member 1122 can be formed at the center area of the protrusion structure 111, and the areas covered by the center hole member 1121 and annular groove member 1122 can be relatively small. That is, even if the warping members 410 of the wafer 400 contact with the end surface of the protrusion structure 111, the wedge-shaped space may not be formed. That is, the situation in which the annular groove member 1122 does not absorb the wafer 400 may not happen. A sealed space can be formed between the end surface of the protrusion and the wafer 400 to ensure that a single circle of holes can absorb the surface of the wafer 400. Thus, the adsorption finger 110 with a combination of the center hole member 1121 and the annular groove member 1122 can have a good adsorption effect, and have a relatively high warping compatibility.

Additionally, the air channel 115 can ultimately extend to the center hole member 1121 and communicate with the center hole member 1121. Meanwhile, during the extension of the air channel 115*,* the air channel 115 can also communicate with the annular groove member 1122 surrounding the center hole member 1121. Thus, the air can be extracted separately from the center hole member 1121 and annular groove member 1122 through the air channel 115 to form the negative pressure areas near the center hole member 1121 and the annular groove member 1122, respectively, to adsorb the wafer 400.

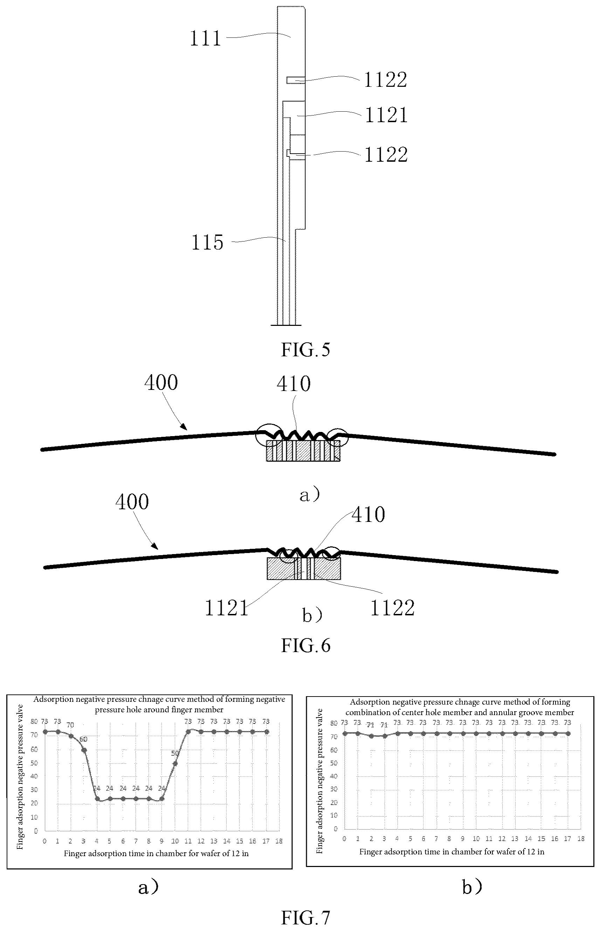

As shown in FIG. 7, compared the adsorption effect of the method of forming the negative pressure holes around the finger member with the adsorption effect the method of forming a combination of the center hole member 1121 and the annular groove member 1122, when an adsorption pressure value is smaller than 40 KPa, the adsorption to the wafer 400 can fail in the method of forming the negative pressure holes around the finger member. A good adsorption effect can be obtained in the method of forming a combination of the center hole member 1121 and the annular groove member 1122.

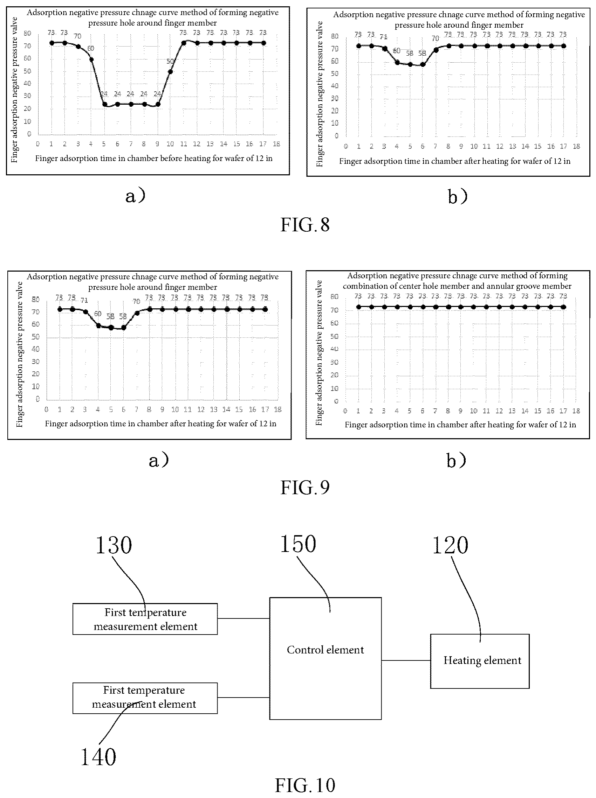

As shown in FIG. 8, a comparison of the adsorption performance of the method of forming the negative pressure holes around the finger member before and after heating is shown. The finger temperature is required to be greater than 60°C before fetching the wafer, and the negative pressure drop of the finger is always greater than 40 KPa. Thus, the adsorption performance is better when the finger temperature is high compared to when the finger temperature is at room temperature.

As shown in FIG. 9, from the comparison of the adsorption performance after heating between the method of forming the negative pressure holes around the finger member and the method of forming the combination of the center hole member 1121 and annular groove member 1122, the adsorption performance of the method of forming the combination of the center hole member 1121 and the annular groove member 1122 is better after heating, and the negative pressure value remain stable without drop.

From the above data comparison, in the method of forming the combination of the center hole member 1121 and annular groove member 1122 at the protrusion structure 111 of the adsorption finger 110, the temperature of the protrusion structure 111 of the adsorption finger 110 can be controlled to reduce the temperature difference between the wafer 400 and the protrusion structure 111 to reach a good adsorption performance.

In some embodiments, the distance between the edge of the annular groove member 1122 and the outer edge of the protrusion structure 111 can be greater than or equal to 10 mm, including 10 mm, 12 mm, 12.5 mm, 15 mm, etc. Of course, other distance values are also possible as long as the distance values meet the actual operational requirements, which are not limited here. In some embodiments, the distance between the outer edge of the annular groove member 1122 and the outer edge of the protrusion structure 111 can be 12.5 mm. With this arrangement, the wedge-shaped space may not be formed after the warping members 410 of the wafer 400 contact the end surface of the protrusion structure 111 to ensure a good adsorption effect.

For example, the cross-section of the center hole member 1121 can be circular. The diameter of the center hole member 1121 can range from 6 mm to 8 mm, including 6 mm, 6.5 mm, 7 mm, 7.5 mm, 8 mm, etc. Of course, other values are also possible, which are not limited here, as long as a sufficient adsorption force can be ensured for the wafer 400. With this arrangement, a good adsorption performance can be realized in the center area of the wafer 400 through the center hole member 1121.

The cross-section of the annular groove member 1122 can be circular. The width of the annular groove member 1122 can range from 2 mm to 4 mm, i.e., a ring width range is 2 mm to 4 mm, such as 2 mm, 2.5 mm, 3 mm, 3.5 mm, 4 mm, etc. Of course, other values are also possible, which are not limited here, as long as sufficient adsorption force on the wafer can be ensured. With this arrangement, a good adsorption performance can be ensured for the wafer 400, and the wedge-shaped space may not be formed to cause the adsorption to fail.

Additionally, the width distance between the inner wall of the center hole member 1121 and the inner wall edge of the annular groove member 1122 can range from 2.5 mm to 4.5 mm, such as 2.5 mm, 3 mm, 3.5 mm, 4 mm, 4.5 mm, etc. With this arrangement, the situation of damaging the wafer 400 due to small areas of the areas of the center hole member 1121 and the annular groove member 1122 contacting the wafer 400 can be avoided. Thus, the wafer 400 can be stably carried, and the wafer 400 can be ensured to be of good quality.

The cross-section of the protrusion structure 111 can be circular, and a diameter of the protrusion structure 111 can range from 38 mm to 42 mm, including 38 mm, 39 mm, 40 mm, 41 mm, 42 mm, etc. Of course, other values are also possible, which are not limited here, as long as the adsorption requirement and the carrying requirement of the wafer 400 are satisfied. Through the design of the protrusion structure 111, a certain contact area can be ensured with the wafer 400 to improve the carrying and adsorption performance to the wafer 400.

Additionally, the thickness of the protrusion structure 111 along a carrying direction can be greater than or equal to 1.5 mm, including 1.5 mm, 1.6 mm, 1.7 mm, 1.8 mm, 2.0 mm, etc. Of course, other values are possible, which are not limited here. It needs to be noted that the thickness of the protrusion structure 111 is limited due to the warping degree of the wafer 400. When the wafer 400 is placed on the end surface of the protrusion structure 111, since the protrusion structure 111 has a certain height, the wafer 400 being unable to be completely attached to the end surface of the protrusion structure 111 due to the large warping degree of the wafer 400 to affect the adsorption performance of the adsorption finger 110 on the wafer 400 can be avoided.

In some embodiments, the thickness of the protrusion can be 1.7 mm. Then, the maximum warping size allowed for the wafer 400 can be 1.7 mm.

In addition, to ensure a proper contact between the wafer 400 and the end surface of the protrusion structure 111 to ensure a good adsorption performance. The surface roughness of the end surface of the protrusion structure in contact with the wafer 400 can range from 0.2 to 0.4, including 0.2, 0.25, 0.3, 0.35, 0.4, etc. Of course, other values are also possible, as long as the wafer 400 is ensured to have a good contact with the end surface of the protrusion structure 111 without forming a gap to cause air leakage.

As shown in FIGs. 2 and 3, in some embodiments, a notch 113 is formed on the surface of the adsorption finger 110. The notch 113 is arranged corresponding to the edge of the wafer 400. By arranging the notch 113, the wafer 400 can be positioned to improve the position accuracy of the wafer 400.

For example, the notch 113 can be an 8-inch notch. That is, the notch corresponding to the edge of the wafer 400 of 8 inches can allow the adsorption finger 110 to be compatible with the wafer 400 smaller than 8 inches. The notch 113 can be a 12-inch notch. That is, the notch corresponding to the edge of the wafer 400 of 12 inches can allow the adsorption finger 110 to be compatible with the wafer 400 smaller than 12 inches. Of course, the notch 113 can have other sizes.

In some embodiments, an 8-inch notch and a 12-inch notch can be arranged on the surface of the adsorption finger 110 to be compatible with the wafer 400 of 8 inches and the wafer 400 of 12 inches.

Further, a recessed structure 114 can be arranged on the surface of the adsorption finger 110. The distance between the side surface of the recessed structure 114 and the notch 113 can be greater than or equal to 5 mm, such as 5 mm, 6 mm, 8 mm, 10 mm, or other sizes, as long as the side surface of the recessed structure 114 does not interfere the outer edge of the wafer 400. With this arrangement, the interference with the wafer 400 can be avoided, and the position of the wafer 400 can be ensured to be within an error range to ensure the position accuracy of the wafer 400.

In some embodiments, the adsorption finger 110 can include a first finger segment and a second finger segment. The protrusion structure 111 can be arranged at an end of the second finger segment away from the first finger segment. The surface of the first finger segment facing the wafer 400 can be lower than the surface of the second finger segment facing the wafer 400, and the recessed structure 114 can be formed at the connection place between the first finger segment and the second finger segment. Thus, the wafer 400 adsorbed by the adsorption member can be ensured not to contact the first finger segment to provide space for warping of the wafer 400. Further, the recessed structure 114 may need to be located outside of the wafer 400 with the maximum size that the adsorption finger 110 can be compatible with to avoid the recessed structure 114 from interfering with the wafer 400. Further, in some embodiments, the first finger segment can have a large thickness to ensure the adsorption finger 110 has enough strength and rigidity. The second finger segment can have a small thickness. That is, the thickness of the second finger segment can be smaller than the thickness of the first finger segment in the carrying direction of the protrusion structure 111.

In some embodiments, when the adsorption finger 110 is compatible with the wafer 400 of 8 inches and the wafer 400 of 12 inches, a certain distance can be formed between the side surface of the recessed structure 114 and the 12-inch notch. Then, the interference to the wafer 400 of 12 inches can be prevented while the position of the wafer of 12 inches can be ensured to be within the error range to ensure the position accuracy of the wafer 400 of 12 inches.

The transfer device in embodiments of the present disclosure can further include a mounting base 200 and a mechanical arm 300. The mounting base 200 can be movably connected to the mechanical arm 300, and the transfer device 100 can be connected to the mounting base 200. Based on this, the mechanical arm 300 can drive the mounting base 200 and the transfer device 100 to move, and the transfer device 100 can drive the wafer 400 to move to achieve the transfer of the wafer 400.

As shown in FIGs. 1 to 17, based on the transfer device 100, embodiments of the present disclosure also provide a wafer transfer method. The wafer transfer method can be applied to the transfer device 100 to adsorb and transfer the wafer 400. The wafer transfer method includes: controlling the adsorption member of the adsorption finger 110 to be below or above the wafer 400;
measuring the temperature of the adsorption member through the first temperature measurement element 130, and measuring the temperature of the wafer 400 through the second temperature measurement element 140;
when the temperature measured by the second temperature sensor 140 is higher than the temperature measured by the first temperature sensor 130, and the difference the temperature measured by the second temperature sensor 140 is higher than the temperature measured by the first temperature sensor 130 is greater than a preset temperature difference, controlling the heating element 120 to heat the adsorption member to cause the difference to be smaller than or equal to the predetermined temperature difference; and
controlling the adsorption member to adsorb the wafer and controlling the adsorption finger 110 to move to transfer the wafer 400.

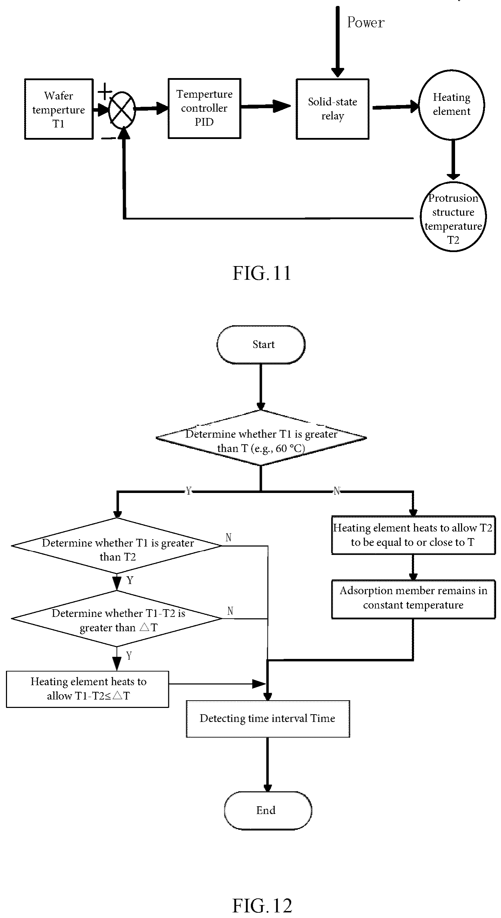

In some embodiments, after controlling the adsorption member of the adsorption finger 110 to be below or above the wafer 400, as shown in FIG. 12, the wafer transfer method includes:
determining whether temperature T1 measured by the second temperature sensor 140 is greater than a preset temperature T (for example, T equals 60°C);
if yes, determining whether temperature T1 measured by the second temperature sensor 140 is greater than temperature T2 measured by the first temperature sensor 130; if no, detecting time interval Time to repeat the above determination process periodically when the time is reached.

If temperature T1 measured by the second temperature sensor 140 is greater than temperature T2 measured by the first temperature sensor 130, whether the difference between temperature T1 and temperature T2 (i.e., T1 - T2) is greater than a preset temperature difference ΔT can be determined. If yes, the heating element 120 can be controlled to heat the adsorption member to cause the difference (i.e., T1-T2) to be smaller than or equal to the preset temperature difference ΔT. Then, time interval Time can be detected, and he above determination process can be repeated periodically when the time is reached. If no, time interval Time can be detected, and the above determination process can be determined when the time is reached.

If temperature T1 measured by the second temperature sensor 140 is smaller than or equal to the preset temperature T (for example, T equals 60°C), the heating element 120 can be controlled to heat the adsorption member to cause temperature T2 measured by the first temperature sensor 130 to equal preset temperature T or be close to preset temperature T. That is, temperature T2 can be maintained within the preset temperature range to allow the adsorption member to maintain a constant temperature. Then, time interval Time can be detected to repeat the above determination processes when the time is reached. For example, preset temperature T can be 60 °C or near 60 °C, such as 59.5 °C, 59.7 °C, 59.9 °C, 60.2 °C, 60.5 °C, or other values, which are not limited here.

In some embodiments, when the adsorption member absorbs the wafer for transfer, the heating element can heat the adsorption member in real time according to the temperatures measured by the first temperature measurement element 130 and the second temperature measurement element 140. In some other embodiments, after a time interval, the heating element 120 can adjust the temperature of the adsorption member according to the temperatures measured by the first temperature measurement element 130 and the second temperature measurement element 140, which is not limited.

In some embodiments, the wafer transfer method can include the following steps.

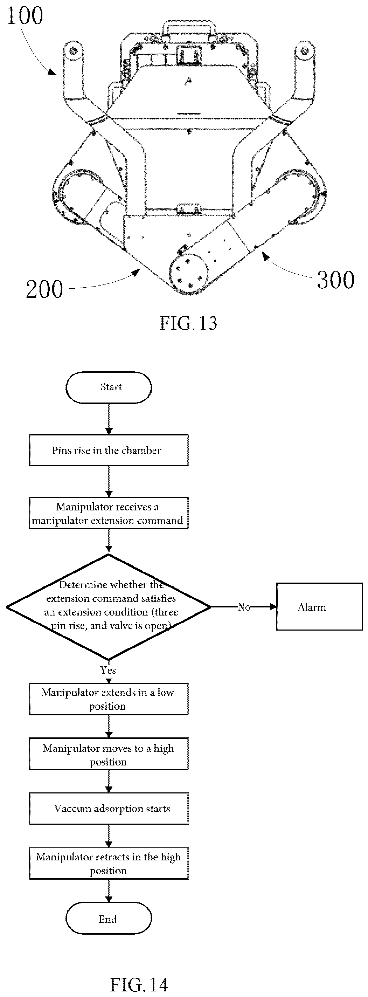

As shown in FIGs. 14 to 17, during operation, three pins of the process chamber rise and lift the wafer 400. The transfer device 100 receives a manipulator extension command and determines whether an extension condition is met, i.e., whether the three pins rise, and whether the valve is opened. When the extension condition is met, the mechanical arm 300 drives the adsorption finger 110 to move below the wafer 400 to the low position of a wafer fetching position. When the extension condition is not met, an alarm is triggered. When the adsorption finger 110 is below the wafer 400, the temperature of the adsorption member can be measured by the first temperature sensor 130, and the temperature of the wafer 400 can be measured by the second temperature sensor 140. The heating element 120 is controlled to heat the adsorption member so that the difference between the temperature of the adsorption member and the temperature of the wafer 400 is smaller than or equal to the preset temperature difference. Thus, the warping of the wafer 400 due to a large temperature difference can be avoided.

When the temperature of the adsorption member rises to be close to the temperature of the wafer 400, the adsorption finger 110 can move upward to allow the adsorption member to contact the lower surface of the wafer 400. As the adsorption finger 110 continues to move upward, the adsorption finger 110 can lift the wafer 400 to cause the wafer 400 to detach from the three pins. Subsequently, the vacuum extraction system can be activated to cause the adsorption member of the adsorption finger 110 to generate a certain vacuum adsorption force. That is, the negative pressure area can be formed around the adsorption member to perform vacuum adsorption on the lower surface of the wafer 400 to ensure that the wafer 400 does not move relative to the adsorption member. Then, the mechanical arm 300 can retract to the high position and drive the adsorption finger 110 and the wafer 400 to move to transfer the wafer 400 to a next working station. Then, the wafer fetching process from the process chamber can be completed. It needs to be noted that when the temperature difference between the wafer 400 and the adsorption finger 110 is small, and after the adsorption finger 110 reaches a position below the wafer 400, the adsorption finger 110 can move upward to cause the adsorption member to contact the lower surface of the wafer 400. The first temperature measurement element 130 can be configured to measure the temperature of the adsorption member, and the second temperature measurement element 140 can be configured to measure the temperature of the wafer 400. The heating element 120 can be controlled to heat the adsorption member to cause the difference between the temperature of the adsorption member and the temperature of the wafer 400 to be smaller than or equal to the preset temperature difference to avoid the warping of the wafer 400 due to a large temperature difference. Then, the vacuum extraction can be performed to ensure that the wafer 400 does not move relative to the adsorption member by performing the vacuum adsorption on the lower surface of the wafer through the adsorption member. Then, the mechanical arm 300 can retract to the high position and drive the adsorption finger 110 and the wafer 400 to move to transfer the wafer 400 to the next working station. Then, the wafer fetching process from the process chamber can be completed.

Based on the above steps, the issue of the warping of the wafer 400 due to uneven temperatures at different positions of the wafer 400 after the adsorption member contacts the wafer 400 is caused by the large temperature difference between the adsorption member and the wafer 400. Thus, the temperature uniformity of the wafer 400 can be ensured by reducing the temperature difference between the adsorption member and the wafer 400 to improve the quality of the wafer 400.

In some embodiments, when the temperature of the adsorption member is lower than the temperature of the wafer 400, the adsorption member can be heated to cause the temperature of the adsorption member to rise to equal to the temperature of the wafer 400.

When the temperature of the adsorption member is higher than the temperature of the wafer 400, the adsorption member can be stopped from heating to allow the temperature of the adsorption member to drop to be equal to the temperature of the wafer 400.

In some embodiments, the heating element 120 can be arranged in the adsorption member. When the temperature of the adsorption member is lower than the temperature of the wafer 400, the heating element 120 can work to transfer heat to the adsorption member to cause the temperature of the adsorption member to rise. Thus, the temperature of the adsorption member can be equal to or close to the temperature of the wafer 400 to alleviate the warping of the wafer 400 due to the uneven temperatures at different positions of the wafer caused by the temperature difference between the wafer 400 and the adsorption member.

On the contrary, during heating, when the temperature of the adsorption member is higher than the temperature of the wafer 400, the heating element 120 can be controlled to stop working or reduce the heating power to reduce the heat transferred to the adsorption member to reduce the temperature of the adsorption member. Then, the temperature of the adsorption member can be equal to or close to the temperature of the wafer 400 to alleviate the warping of the wafer 400 due to the uneven temperatures at different positions of the wafer caused by the temperature difference between the wafer 400 and the adsorption member.

When the adsorption member does not adsorb the wafer 400, or the wafer 400 adsorbed by the adsorption member is in the room-temperature status, the temperature control method can include:
adjusting the temperature of the adsorption member to cause the temperature of the adsorption member to reach the first preset temperature and keep a constant temperature. For example, the first preset temperature can be 60 °C.

In some embodiments, when the adsorption member 110 does not adsorb the wafer 400, the temperature measured by the second temperature measurement element 140 can be the ambient temperature. Then, the control element 150 can be configured to control the temperature of the protrusion structure 111 to be at the first preset temperature or close to the first preset temperature and cause the protrusion structure 111 to maintain a constant temperature.

When the temperature of the wafer 400 adsorbed by the adsorption finger 110 is at the room temperature, the temperature measured by the second temperature measurement element 140 can be the room temperature. Then, the control element 150 can be configured to control the temperature of the protrusion structure 111 to be at the first preset temperature or close to the first preset temperature and cause the protrusion structure 111 to maintain a constant temperature.

Embodiments of the present disclosure have been described above with reference to the accompanying drawings. However, the present disclosure is not limited to specific embodiments described above, which are merely illustrative but not restrictive. Under the guidance of the present disclosure, those skilled in the art can derive various modifications without departing from the spirit and scope defined by the claims. All of the modifications are within the scope of the present disclosure.

## Claims

1. A transfer device configured to adsorb and transfer a wafer comprising an adsorption finger, a heating element, a first temperature measurement element, a second temperature measurement element, and a control element, wherein:
the adsorption finger includes an adsorption member configured to adsorb the wafer, the heating element and the first temperature measurement element are arranged at the adsorption member, the second temperature measurement element is arranged at the adsorption finger and spaced apart from the adsorption member, and the second temperature measurement element is configured to measure temperature above or below the adsorption finger; and
the control element is electrically connected to the heating element, the first temperature measurement element, and the second measurement element, the control element is configured to, when a temperature measured by the second temperature measurement element is higher than a temperature measured by the first temperature measurement element, and a difference between the temperature measured by the second temperature measurement element and the temperature measured by the first temperature measurement element is greater than a preset temperature difference, control the heating element to heat the adsorption member to cause the difference to be smaller than or equal to the preset temperature difference.

2. The transfer device according to claim 1, wherein the control element is further configured to control the heating element to heat the adsorption member when the temperature measured by the second temperature measurement element is less than or equal to a preset temperature, to cause the temperature measured by the first temperature measurement element to maintain within a preset temperature range.

3. The transfer device according to claim 1 or 2,
wherein:
the adsorption member includes a protrusion structure, and an adsorption hole is formed at an end surface of the protrusion structure in contact with the wafer; and
the heating element and the first temperature measurement element are arranged inside the protrusion structure;
the transfer device further comprising an air channel arranged at the adsorption finger and communicating with the adsorption hole.

4. The transfer device according to claim 3, wherein:
the adsorption hole is arranged in a center area of the end surface of the protrusion structure in contact with the wafer; and
a distance between an edge of the adsorption hole and an edge of the protrusion structure is greater than or equal to 10 mm.

5. The transfer device according to claim 3, wherein:
the adsorption hole includes a center hole member and an annular groove member; and
the center hole member is arranged at a center of the end surface, the annular groove member is arranged around the center hole member, and the air channel communicates with the center hole member and the annular groove member.

6. The transfer device according to claim 5, wherein a distance between an outer edge of the annular groove member and an outer edge of the protrusion structure is greater than or equal to 10 mm, and a size of the protrusion structure is less than or equal to 42 mm.

7. The transfer device according to claim 5, wherein:
a cross section of the center hole member is circular with a diameter of the center hole member ranging from 6 mm to 8 mm;
a cross section of the annular groove member is annular with a width of the annular groove member ranging from 2 mm to 4 mm; and/or
a cross section of the protrusion structure is circular with a diameter of the protrusion structure ranging from 38 mm to 42 mm.

8. The transfer device according to claim 3, wherein:
a thickness of the protrusion structure in a carrying direction is greater than or equal to 1.5 mm; and/or
a surface roughness of the end surface of the protrusion structure in contact with the wafer ranges from 0.2 to 0.4.

9. The transfer device according to claim 3, wherein a notch is formed on a surface on a side of the adsorption finger facing the wafer and is configured to be arranged corresponding to an edge of the wafer.

10. The transfer device according to claim 9, wherein:
the adsorption finger includes a first finger segment and a second finger segment, the protrusion structure being arranged at an end of the second finger segment away from the first finger segment; and
a surface of the first finger segment facing the wafer is lower than a surface of the second finger segment facing the wafer, a recessed structure is formed at a connection place between the first finger segment and the second finger segment, and a distance between a side surface of the recessed structure and the notch is greater than or equal to 5 mm.

11. Semiconductor process equipment comprising the transfer device according to any one of claims 1 to 10.

12. A wafer transfer method, applied to the transfer device according to any one of claims 1 to 10, comprising:
controlling the adsorption member of the adsorption finger to be below or above the wafer;
measuring a temperature of the adsorption member by the first temperature measurement element, and measuring a temperature of the wafer by the second temperature measurement element;
when the temperature measured by the second temperature measurement element is higher than the temperature measured by the first temperature measurement element, and the difference between the temperature measured by the second temperature measurement element and the temperature measured by the first temperature measurement element is greater than a preset temperature difference, controlling the heating element to heat the adsorption member to cause the difference to be less than or equal to the preset temperature difference; and
controlling the adsorption member to adsorb the wafer, and controlling the adsorption finger to move to transfer the wafer.

13. The wafer transfer method according to claim 12, further comprising, when the temperature measured by the second temperature measurement element is less than or equal to the preset temperature, controlling the heating element to heat the adsorption member to cause the temperature measured by the first temperature measurement element to maintained within a preset temperature range.
